(19) Europäisches Patentamt
European Patent Office
Office européen des brevets

(11) **EP 4 379 019 B1**

(12) **EUROPEAN PATENT SPECIFICATION**

(45) Date of publication and mention
of the grant of the patent:
**25.03.2026  Bulletin 2026/13**

(21) Application number: **24170130.9**

(22) Date of filing: **15.04.2024**

(51) International Patent Classification (IPC):
**C09K 11/66** (2006.01)

(52) Cooperative Patent Classification (CPC):
**C09K 11/665**

(54) **PEROVSKITE NANOCRYSTAL FLUORESCENT MATERIALS AND PREPARATION METHODS AND APPLICATIONS THEREOF**

FLUORESZIERENDE PEROWSKIT-NANOKRISTALLMATERIALIEN SOWIE HERSTELLUNGSVERFAHREN UND ANWENDUNGEN DAVON

MATÉRIAUX FLUORESCENTS NANOCRISTALLINS DE PÉROVSKITE ET LEURS PROCÉDÉS DE PRÉPARATION ET APPLICATIONS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **25.05.2023  CN 202310599312**

(43) Date of publication of application:
**05.06.2024  Bulletin 2024/23**

(73) Proprietor: **Wenzhou Xinxintaijing Tech. Co., Ltd. Wenzhou, Zhejiang 325000 (CN)**

(72) Inventors:
• **FAN, Chao**
  **Wenzhou, 325000 (CN)**
• **DAI, Xingliang**
  **Wenzhou, 325000 (CN)**
• **HE, Haiping**
  **Wenzhou, 325000 (CN)**
• **YE, Zhizhen**
  **Wenzhou, 325000 (CN)**

(74) Representative: **Dai, Simin**
  **Reyda IP**
  **A073**
  **157, Quai du Président Roosevelt**
  **92130 Issy-les-Moulineaux (FR)**

(56) References cited:
**WO-A1-2022/024037    CN-A- 114 316 969**

EP 4 379 019 B1

**Description**

**TECHNICAL FIELD**

The present disclosure relates to the technical field of preparing a perovskite nanocrystal fluorescent material.

**BACKGROUND**

The perovskite nanocrystal fluorescent material is an emerging semiconductor material with excellent properties such as high luminous efficiency, narrow luminescence peak width, tunable luminescence wavelength, and large defect tolerance, which makes the perovskite nanocrystal valuable for commercial applications in high-quality displays and light-emitting devices.

How to make the perovskite nanocrystal fluorescent material maintain a high luminous efficiency while improving the luminescence stability of the perovskite nanocrystal fluorescent material has become an urgent problem to be solved. Currently, the perovskite nanocrystal fluorescent material is usually prepared by a liquid phase method that requires the assistance of an organic solvent. The organic solvent is usually toxic, and the uniformity of the liquid phase reaction is difficult to control, which is not conducive to the green synthesis and large-scale preparation of the perovskite nanocrystal, and restricts the development of the perovskite nanocrystals' practical commercialization in the lighting and display devices. A melt crystallization method is currently a common method for the large-scale preparation of a semiconductor material (e.g., monocrystalline silicon, germanium, etc.). However, the application of the melt crystallization method to the large-scale preparation of the perovskite nanocrystal needs to solve two technical problems: 1. the semiconductor material prepared by the melt crystallization method usually has a large-size wafer rather than a nanocrystal of nanometer size; 2. a crystal formed during the melt crystallization process lacks a surface passivation mechanism, and a luminous property of the perovskite nanocrystal is very sensitive to a surface defect, the surface defect tends to form a non-radiative complex center of carriers, thus reducing the luminous efficiency and luminescence stability of the perovskite nanocrystal. WO 2022/024037A1 relates to a method for the preparation of luminescent nanocomposites comprising metal halide nanocrystals co-embedded with inorganic salts in the pores of a porous metal oxide matrix. CN 114316969 A relates to a perovskite quantum dot, a preparation method thereof, and a quantum dot device.

Therefore, it is desired to provide a method for preparing a perovskite nanocrystal fluorescent material with a simple procedure, a controllable crystallization process, a green environment, high luminous efficiency, and luminescence stability, and can achieve large-scale production.

**SUMMARY**

The invention is set out in the appended set of claims. Embodiments which do not fall within the wording of the claims are only given as useful examples for understanding the invention. One or more embodiments of the present disclosure provide a method for preparing a perovskite nanocrystal fluorescent material, comprising the following steps: (1) mixing a precursor of a perovskite nanocrystal, a precursor of a substrate, and at least one of a micro-porous template or a mesoporous template to obtain a mixture; and (2) under a temperature higher than a melting point of the perovskite nanocrystal and lower than a failure temperature of the at least one of the micro-porous template or the mesoporous template, performing calcination on the mixture obtained in step (1), and after cooling the mixture to a room temperature, obtaining the perovskite nanocrystal fluorescent material. The calcination in step (2) is composed of a heating-melting stage, an insulation-filling stage, and a cooling-growth stage in sequence; during the heating-melting stage, when a calcination temperature is higher than the melting point of the perovskite nanocrystal, the precursor of the perovskite nanocrystal and the precursor of the substrate form a molten liquid; during the insulation-filling stage, when the calcination temperature is lower than the failure temperature of the at least one of the micro-porous template or the mesoporous template, the molten liquid fills a pore structure of the at least one of the micro-porous template or the mesoporous template; and during the cooling-growth stage, the substrate is formed inside the micro-porous template or the mesoporous template, and after the substrate is formed, the perovskite nanocrystal heterogeneously grows on a surface of the substrate, thus obtaining the perovskite nanocrystal fluorescent material; a melting point of the precursor of the substrate is lower than a melting point of the substrate; the substrate is arranged on an inner surface of the at least one of the micro-porous template or the mesoporous template; a lattice of the perovskite nanocrystal stacks with a lattice of the substrate to form a passivation interface; and the melting point of the substrate is higher than the melting point of the perovskite nanocrystal.

**BRIEF DESCRIPTION OF THE DRAWINGS**

This description will be further explained in the form of exemplary embodiments, which will be described in detail by means of accompanying drawings. These embodiments are not restrictive, in which the same numbering indicates the same structure, wherein:

> FIG. 1 is a schematic diagram illustrating a structure of a perovskite nanocrystal fluorescent material according to some embodiments of the present disclosure;

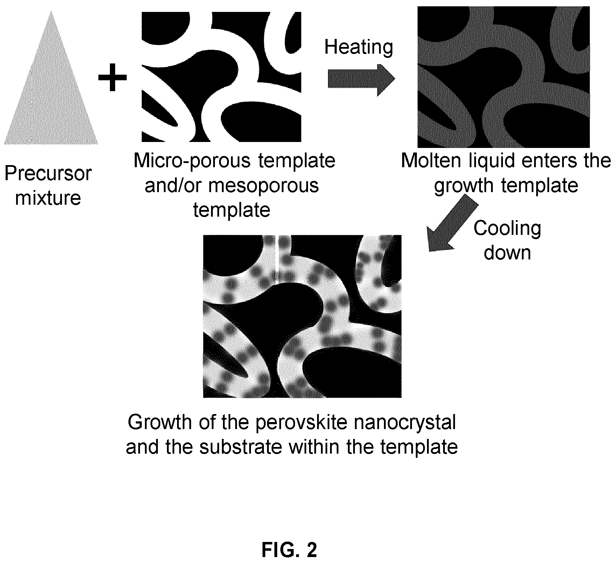

> FIG. 2 is a flowchart illustrating a method for preparing a perovskite nanocrystal fluorescent material according to some embodiments of the present disclosure;
> FIG. 3 is a diagram illustrating X-ray diffraction spectra of samples obtained according to Embodiments 1-4 and Comparative embodiment 1 of the present disclosure;
> FIG. 4 is a diagram illustrating PLQY test results of samples obtained according to Embodiments 1-4 and Comparison example 1 of the present disclosure;
> FIG. 5 is a diagram illustrating proportionality values of a luminous intensity compared to an initial intensity after a blue light aging test for samples obtained according to Embodiments 1-4 and Comparative embodiment 1 of the present disclosure;
> FIG. 6 is a transmission electron micrograph of a sample obtained according to Embodiment 1 of the present disclosure;
> FIG. 7 is an X-ray diffraction spectrum of a sample obtained according to Embodiment 7 of the present disclosure;
> FIG. 8 is a transmission electron micrograph of a sample obtained according to Comparative embodiment 2 of the present disclosure; and
> FIG. 9 is a histogram illustrating luminous intensities of samples with mass ratios of $CaF/CsPbBr_3$ of 0.02, 0.2, and 10, respectively, obtained according to Comparative embodiment 3 of the present disclosure.

## DETAILED DESCRIPTION

The technical schemes of embodiments of the present disclosure will be more clearly described below, and the accompanying drawings that need to be configured in the description of the embodiments will be briefly described below. Obviously, the drawings in the following description are merely some examples or embodiments of the present disclosure and will be applied to other similar scenarios according to these accompanying drawings without paying creative labor. Unless obviously obtained from the context or the context illustrates otherwise, the same numeral in the drawings refers to the same structure or operation.

As shown in the present disclosure and claims, unless the context clearly prompts the exception, "a," "one," and/or "the" is not specifically singular, and the plural may be included. It will be further understood that the terms "comprise," "comprises," and/or "comprising," "include," "includes," and/or "including," when used in present disclosure, specify the presence of stated features, integers, steps, operations, elements, and/or components, but do not preclude the presence or addition of one or more other features, integers, steps, operations, elements, components, and/or groups thereof.

The perovskite nanocrystal is a remarkable kind of photoelectric material whose fluorescent property and semiconducting properties make it promising for a wide range of applications in the field of optoelectronics. However, there are several challenges in current preparation methods that limit their development in practical commercial lighting and display devices.

Currently, a liquid phase method commonly used for preparing a perovskite nanocrystal usually requires the assistance of an organic solvent, which is toxic and the reaction homogeneity is difficult to control, thus being not conducive to green synthesis and large-scale preparation.

Melt crystallization is a widely used method for the preparation of semiconductor materials, however, its application to the large-scale preparation of perovskite nanocrystal still faces two major technical problems. First, the melt crystallization method usually generates large-sized wafers rather than nanoscale nanocrystals. Second, the crystal formed during the melt crystallization process lacks a surface passivation mechanism, and the perovskite nanocrystal is extremely sensitive to a surface defect, which may affect their luminous efficiency and stability.

By attaching a substrate with a more stable lattice to an inner surface of a micro-porous template and/or a mesoporous template, the embodiments of the present disclosure improve the structural stability of the micro-porous template and/or the mesoporous template, and a perovskite nanocrystal is heterogeneously grown on a crystal surface of the substrate so as to stacked form the perovskite nanocrystal on the substrate, realizing the passivation of surface defects of the perovskite nanocrystal, and at the same time, improving the stability of the perovskite nanocrystal, thereby enhancing the luminous quantity and luminous stability of the perovskite nanocrystal fluorescent material. The embodiments of the present disclosure bring new possibilities in the field of optoelectronics by realizing a greener, sustainable, and controllable preparation process for the perovskite nanocrystal and promoting their development in practical applications.

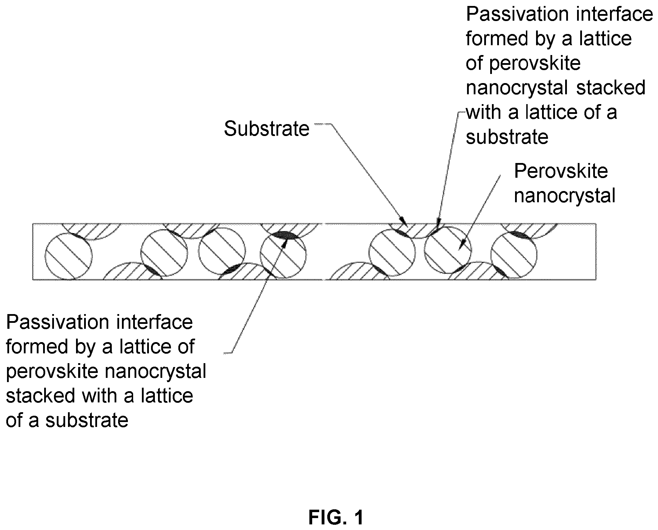

One or more embodiments of the present disclosure provide a perovskite nanocrystal fluorescent material comprising a micro-porous template and/or a mesoporous template and a perovskite nanocrystal, a substrate being arranged on an inner surface of the micro-porous template and/or the mesoporous template. As shown in FIG. 1, a lattice of the perovskite nanocrystal is stacked with a lattice of the substrate to form a passivation interface, and a melting point of the substrate is higher than a melting point of the perovskite nanocrystal.

The micro-porous template and/or the mesoporous template is a material that can be used to prepare a specific pore structure. The pore structure may be set to a nanoscale, thereby affecting the properties and applications of the material. In some embodiments, the template may be an organic or inorganic material.

A micropore refers to a small pore with a diameter in a range of 1 to 2 nanometers.

A mesopore refers to a pore with a diameter between the micropore and a macropore, typically in a range of 2 to 50 nanometers in diameter.

Methods of using the micro-porous template and/or the mesoporous template include a sol-gel method, a template method, a vapor-phase deposition, etc., which allow control of the pore structure and distribution during the synthesis of the material to meet the needs of different applications.

In some embodiments, the micro-porous template and/or the mesoporous template is a micro-porous material and/or a mesoporous material.

In some embodiments, the micro-porous material is at least one of microporous molecular sieve, microporous silica, microporous titanium dioxide, microporous alumina, microporous transition metal oxide, microporous sulfide, microporous silicate, microporous aluminosilicates, or microporous transition metal nitride. The mesoporous material is at least one of mesoporous molecular sieve, mesoporous silica, mesoporous titanium dioxide, mesoporous alumina, mesoporous carbon, mesoporous transition metal oxide, mesoporous sulfide, mesoporous silicate, mesoporous aluminosilicate, or mesoporous transition metal nitride.

In some embodiments, the micro-porous material is microporous molecular sieve, microporous silica, microporous titanium dioxide, microporous alumina, microporous transition metal oxide, microporous sulfide, microporous silicate, microporous aluminosilicates, or microporous transition metal nitride. In some embodiments, the mesoporous material is mesoporous molecular sieve, mesoporous silica, mesoporous titanium dioxide, mesoporous alumina, mesoporous carbon, mesoporous transition metal oxide, mesoporous sulfide, mesoporous silicate, mesoporous aluminosilicate, or mesoporous transition metal nitride.

In some embodiments of the present disclosure, the size of the perovskite crystal grown in the template pores is effectively controlled by the spatial domain-limiting effect of the microporous template and/or the mesoporous template, which in turn results in nanocrystal. This not only allows for the continued adsorption of a larger amount of the perovskite nanocrystals, but also increases the amount of luminosity of the perovskite nanocrystal fluorescent material.

In some embodiments, the perovskite nanocrystal may include at least one of a cesium halide perovskite nanocrystal or a mixed halide perovskite nanocrystal.

In some embodiments, the perovskite nanocrystal is the cesium halide perovskite nanocrystal or the mixed halide perovskite nanocrystal.

The cesium halide perovskite nanocrystal is a nanocrystal structure composed of cesium, halogen elements (e.g., chlorine, bromine, etc.), calcium, and titanium. The cesium halide perovskite nanocrystal usually belongs to a variant of the perovskite structure and has a nanoscale dimension, i.e., the diameter of the grain is in a nanoscale range.

In some embodiments, the cesium halide perovskite nanocrystal has a perovskite structure $ABX_3$, where A, B, and X have a molar ratio of 1:1:3, A is Cs, B is Pb, Sn, or Cu, and X is Cl, Br, or I.

The mixed halide perovskite nanocrystal refers to a nanocrystal structure composed of a mixture of halogen elements, calcium, and titanium. Such material is characterized by the mixed use of halogen elements. For example, the mixed halide perovskite nanocrystal may include halogens such as chlorine, bromine, iodine, or any combination thereof.

In some embodiments, the mixed halide perovskite nanocrystal has a perovskite structure $ABX_yX'_{3-y}$, where A, B, X, and X' have a molar ratio of 1:1:y:3-y, y is between 0 and 3, A is Cs, B is Pb, Sn, or Cu, X and X' are different and independently Cl, Br, or I.

The substrate is a substance arranged on the inner surface of the micro-porous template and/or the mesoporous template, which is stacked with the lattice of the perovskite nanocrystal to form a passivation interface.

As described herein, "perovskite/epitaxial substrate stack," "perovskite/substrate interface," and "passivation interface" in the present disclosure have the same meaning, and all refer to the interface formed by the lattice stacking of the perovskite nanocrystal and the substrate.

In some embodiments, the substrate is one of metal oxide, metal fluoride, phosphate, lead-tellurium-oxide halides, or a combination thereof. Specifically, in some embodiments, the metal oxide may be BaO, CaO, or $Al_2O_3$, the metal fluoride may be $CaF_2$ or $BaF_2$, the phosphate may be $Pb_3(PO_4)_2$ or $AlPO_4$, and the lead-tellurium-oxide halides may be $Pb_3TeO_4X_2$, where X is Br, I, or Cl.

In some embodiments, the melting point of the substrate is higher than a failure temperature of the micro-porous template and/or the mesoporous template, and the failure temperature of the micro-porous template and/or the mesoporous template is higher than the melting point of the perovskite nanocrystal.

The failure temperature of the micro-porous template and/or the mesoporous template refers to a temperature at which the micro-porous template and/or the mesoporous template undergo pore collapse. Different growth templates have different failure temperatures. Controlling the calcination temperature to a temperature range below the failure temperature of the growth template may ensure that the template provides an effective domain-limiting space for the melt to ensure that a size of a final product is in the nanometer range. For example, a pore channel of mesoporous silica begins to collapse at a temperature of 600 °C. When the mesoporous silica is used as the template for the growth of the perovskite nanocrystal, the failure temperature is 600 °C., and the calcination temperature needs to be lower than 600 °C. As another example, a pore channel of mesoporous titanium dioxide begins to collapse at a temperature of 800° C. When the mesoporous titanium dioxide is used as the template for the growth of the perovskite nanocrystal, the failure temperature is 800 °C, and the calcination temperature needs to be lower than 800 °C.

In some embodiments, when the mesoporous silica is used as the growth template for the perovskite nanocrystal, the selected substrate has a melting point higher than 570°C, and the selected perovskite nanocrystal has a melting point no higher than 570°C.

The substrate of the perovskite nanocrystal fluorescent material provided by the embodiments of the present disclosure has a high melting point, so the lattice of the substrate has a high lattice energy, improving the stability of the substrate, and avoiding the structure of the substrate from being destroyed in calcination. The embodiments of the present disclosure set the substrate on the inner surface of the micro-porous template and/or the mesoporous template, which may serve to strengthen the stability of the micro-porous template and/or the mesoporous template, enhance the structural strength of the micro-porous template and/or the mesoporous template, and be favorable to a subsequent production and processing of the perovskite nanocrystal fluorescent material. On the other hand, the passivation interface formed by stacking the substrate with the lattice of the perovskite nanocrystal makes the perovskite nanocrystal have increased structural stability under the protection of this passivation interface. Meanwhile, this passivation interface reduces the defects on the surface of the perovskite nanocrystal, realizes surface passivation, and improves the luminous efficiency of the perovskite nanocrystal.

In some embodiments, a mass ratio of the substrate to the perovskite nanocrystal is denoted as a, and a ranges between 0.02 and 10.

The mass ratio of the substrate to the perovskite nanocrystal can affect the luminous properties of perovskite. If the content of the substrate is too small, it cannot play the role of passivating the perovskite nanocrystal and stabilizing the structure of the perovskite nanocrystal; whereas if the content of the substrate is too large, it may crowd a growth space of the perovskite nanocrystal, leading to a decrease in the content of the perovskite nanocrystal, which in turn weakens the luminosity of the perovskite nanocrystal fluorescent material.

The present disclosure provides a method for preparing a perovskite nanocrystal fluorescent material, comprising the following steps:

(1) mixing a precursor of the perovskite nanocrystal, a precursor of the substrate, and the micro-porous template and/or the mesoporous template to obtain a mixture.

The precursor of the perovskite nanocrystal refers to a starting substance or compound used in the preparation of the perovskite nanocrystal, usually prepared by a chemical synthesis method. The precursor includes a compound including calcium, titanium, and appropriate halogen elements (e.g., chlorine, bromine, etc.). During the preparation process, the precursor undergoes a series of chemical reactions, heat treatments, or other processing steps that culminate in the formation of the crystal structure of the perovskite nanocrystal.

In some embodiments, the precursor of the perovskite nanocrystal may be a precursor of the cesium halide perovskite nanocrystal or a precursor of the mixed halide perovskite nanocrystal.

In some embodiments, the precursor of the cesium halide perovskite nanocrystal is a precursor of the perovskite nanocrystal having the perovskite structure $ABX_3$, where A, B, and X have a molar ratio of 1:1:3, A is Cs, B is Pb, Sn, or Cu, and X is Cl, Br, or I. A precursor of $CsPbX_3$ perovskite nanocrystal includes a Cs source precursor, a Pb source precursor, and an X source precursor; a precursor of $CsSnX_3$ perovskite nanocrystal includes the Cs source precursor, a Sn source precursor, and the X source precursor; a precursor of $CsCuX_3$ perovskite nanocrystal includes the Cs source precursor, a Cu source precursor, and the X source precursor; and the X source precursor is a halide source precursor.

In some embodiments, the precursor of the mixed halide perovskite nanocrystal is a precursor of the perovskite nanocrystal having the perovskite structure $ABX_yX'_{3-y}$, where A, B, X, and X' have a molar ratio of 1:1:y:3-y, y is between 0 and 3, A is Cs, B is Pb, Sn, or Cu, X and X' are different and independently Cl, Br, or I. A precursor of $CsPbX_yX'_{3-y}$ perovskite nanocrystal includes the Cs source precursor, the Pb source precursor, the X source precursor, and an X' source precursor; a precursor of $CsSnX_yX'_{3-y}$ perovskite nanocrystal includes the Cs source precursor, the Sn source precursor, the X source precursor, and the X' source precursor; a precursor of $CsCuX_yX'_{3-y}$ perovskite nanocrystal includes the Cs source precursor, the Cu source precursor, the X source precursor, and the X' source precursor; and the X source precursor and the X' source precursor are different halide source precursors.

In some embodiments, the Cs source precursor is one or more of cesium halide and cesium carbonate; the Pb source precursor is one or more of lead halide and lead acetate; the Sn source precursor is tin halide; the Cu source precursor is copper halide; the halide source precursor is one or more of cesium halide, lead halide, zinc halide, potassium halide, sodium halide, lithium halide, ammonia halide, calcium halide, strontium halide, and barium halide.

The precursor of the substrate is a starting substance or compound used in the preparation of the substrate.

In some embodiments, the precursor of the substrate may be one or more of nitrate, nitrite, telluride, and hydrogen phosphate. Specifically, in some embodiments, the nitrate is $Ce(NO_3)_3$, the nitrite is $Ba(NO_2)_2$ or $Ca(NO_2)_2$, the telluride is $TeO_2$, $TeCl_4$, or $TeBr_4$, and the phosphate is $Al(H_2PO_4)_3$.

In some embodiments, a melting point of the precursor of the substrate is lower than the calcination temperature.

The melting point of the precursor of the substrate is lower than the melting point of the substrate.

In some embodiments, a low melting point salt from any precursor of the precursor of the perovskite nanocrystal, and the precursor of the substrate are used as a flux.

The low melting point salt refers to a salt compound that melts into liquid at a relatively low temperature. This property allows them to act as the flux in some high temperature treatments or syntheses, helping to lower the reaction temperature, facilitate the melting reaction, and provide a better reaction condition. The low melting point salt includes, but is not limited to, sodium chloride, potassium chloride, and calcium fluoride.

In some embodiments, the flux may react with other salts in the precursors and have a lower melting point than the other salts. In some embodiments, the flux is present in the reaction system as both a precursor and a flux.

In some embodiments, the low melting point salt may be $PbBr_2$, $SnBr_2$, or CuI.

In some embodiments of the present disclosure, when the melting point of the precursor of the substrate is lower than the calcination temperature, or after the addition of the flux, a co-melting point of the precursor of the substrate and the precursor of the perovskite nanocrystal is lower than the calcination temperature. At the calcination temperature, the precursor of the substrate and the precursor of the perovskite nanocrystal are capable of co-melting and reacting to obtain the substrate and the perovskite nanocrystal in a molten state, respectively. The substrate and the perovskite nanocrystal in the molten state may enter the interior of the pores of the micro-porous template and/or the mesoporous template, and at the same time, the melting point of the formed substrate is higher than that of the perovskite nanocrystal, so that the substrate may serve to enhance and stabilize the structure.

(2) Under a condition where a temperature is higher than the melting point of the perovskite nanocrystal and lower than the failure temperature of the micro-porous template and/or the mesoporous template, the calcination is performed on the mixture obtained in step (1), and after cooling the mixture to a room temperature, the perovskite nanocrystal fluorescent material is obtained.

The calcination in step (2) is composed of a heating-melting stage, an insulation-filling stage, and a cooling-growth stage in sequence. During the heating-melting stage, when the calcination temperature is higher than the melting point of the perovskite nanocrystal, the precursor of the perovskite nanocrystal and the precursor of the substrate form a molten liquid. During the insulation-filling stage, when the calcination temperature is lower than the failure temperature of the micro-porous template and/or the mesoporous template, the molten liquid fills a pore structure of the micro-porous template and/or the mesoporous template. During the cooling-growth stage, the substrate is formed inside the micro-porous template and/or the mesoporous template, and after the substrate is formed, the perovskite nanocrystal heterogeneously grows on an inner surface of the substrate, thus obtaining the perovskite nanocrystal fluorescent material.

In some embodiments of the present disclosure, upon high temperature calcination, the precursor of the perovskite nanocrystal and the precursor of the substrate melt and react to generate the perovskite nanocrystal and the substrate. Since the calcination temperature is lower than the failure temperature of the micro-porous template and/or the mesoporous template, the pores of the generated template remain intact throughout the calcination process. The adsorption capacity of the pore structure of the micro-porous template and/or the mesoporous template was utilized to draw the perovskite nanocrystal and the substrate in the molten state into the spatial pores of the micro-porous template and/or the mesoporous template. The calcination temperature is then lowered, and since a solidification point of the substrate is higher than that of the perovskite nanocrystal, the substrate is formed first in the inner surface of the spatial pores of the micro-porous template and/or the mesoporous template. As the temperature decreases to the solidification point of the perovskite, according to the principle of lowest energy, the perovskite crystallizes and grows attached to the surface of the substrate, and the lattice of the perovskite nanocrystal is stacked with that of the substrate to form a passivation interface. The formed passivation interface can passivate the surface defect of the perovskite nanocrystal, thus effectively enhancing the luminous performance of the perovskite nanocrystal. In addition, the luminous stability of the perovskite nanocrystal is improved due to the support of the lattice stabilized substrate. Moreover, because the growth of the perovskite nanocrystal within the spatial pores of the micro-porous template and/or the mesoporous template limits the size of the perovskite nanocrystal, the perovskite nanocrystal with suitable grain size and a large number of perovskite nanocrystals are obtained, which ensures that the perovskite nanocrystal fluorescent material has a good luminous performance.

The beneficial effects of embodiments of the present disclosure include, but are not limited to: (I) by attaching the substrate with a more stable lattice to the inner surface of the micro-porous template and/or the mesoporous template, the structural stability of the microporous template and/or the mesoporous template is improved, and the perovskite nanocrystal is heterogeneously grown on the crystal surface of the substrate so as to stacked form the perovskite nanocrystal on the substrate, realizing the passivation of the surface defects of the perovskite nanocrystal while enhancing the stability of the perovskite nanocrystal, thereby enhancing the luminous quantity and luminous stability of the perovskite nanocrystal fluorescent material; due to the use of the micro-porous template and/or the mesoporous template, the growth space for the substrate and the perovskite nanocrystal is provided, which limits the grain size of the perovskite nanocrystal, thereby forming the nanocrystal scale, and obtaining a suitable grain size and a larger amount of perovskite nanocrystals, which ensures the luminosity of the perovskite nanocrystal fluorescent material; (II) through the melt crystallization method, the precursor of the substrate and the precursor of the perovskite nanocrystal are first co-melted and reacted to obtain the substrate with a higher melting point and the perovskite nanocrystal with a relatively lower melting point; in the process of calcination, the collapse of the pores of the microporous template and/or the mesoporous template is avoided, so that the molten substrate and the perovskite nanocrystal are capable of continuously entering the pores of the microporous template and/or the mesoporous template, and in the process of temperature reduction, the substrate is first formed in the inner surface of the microporous template and/or the mesoporous template, and when the temperature was lowered to the melting temperature of the perovskite nanocrystal, the perovskite nanocrystal is heterogeneously grown on the crystal surface of the substrate, and ultimately the perovskite nanocrystal fluorescent material is formed; (III) the preparation method provided in the embodiments of the present disclosure does not require an organic solvent, and the preparation process is more green and environmentally friendly; (IV) the melt crystallization method adopted in the embodiments of the present disclosure has a simple and controllable process, which is suitable for large-scale preparation of perovskite nanocrystal; (V) the perovskite nanocrystal fluorescent material provided by the embodiments of the present disclosure is capable of being applied in perovskite diffusion panels, light emitting devices, wavelength conversion films, quantum dot films, light emitting diodes and masterbatches of quantum dots, and so on, and a downstream product industrialization can be realized.

A perovskite nanocrystal fluorescent material and a preparation method and application thereof provided by embodiments of the present disclosure are further described below by way of specific embodiments.

The following embodiments are some more specific illustrations of embodiments related to some of the above embodiments. Some of these embodiments may also be replaced or combined with corresponding elements in other embodiments to form new embodiments. The experimental methods in the following embodiments are conventional if not otherwise specified. The test materials used in the following embodiments are, unless otherwise specified, purchased from a conventional biochemical reagent company. The quantitative tests in the following embodiments were set up to repeat the experiments three times, and the results were averaged. It should be understood that the following embodiments are intended to better explain the present disclosure and are not intended to limit the present disclosure.

**Embodiment 1**

The substrate in the perovskite nanocrystal fluorescent material prepared in this embodiment was BaO, and the perovskite nanocrystal was $CsPbBr_3$ perovskite nanocrystal.

5 mmol of CsBr, 5 mmol of $PbBr_2$, 5 mmol of $Ba(NO_2)_2$, and 2 g of mesoporous silica were ground and mixed to obtain a solid mixed powder.

The above mixed powder was placed in a muffle furnace and heated from the room temperature to 585 °C. After heated continuously at 585 °C for 40 minutes, the sample powder was naturally cooled down to the room temperature and then removed.

During the calcination process, $Ba(NO_2)_2$ was heated to melt and adsorbed into the mesoporous silica pore, and further heated to decompose into BaO as the substrate for the perovskite nanocrystal. The melting point of $Ba(NO_2)_2$ is 267 °C and the melting point of BaO is 1920 °C. The CsBr and $PbBr_2$ melt and react to form the $CsPbBr_3$ perovskite nanocrystal.

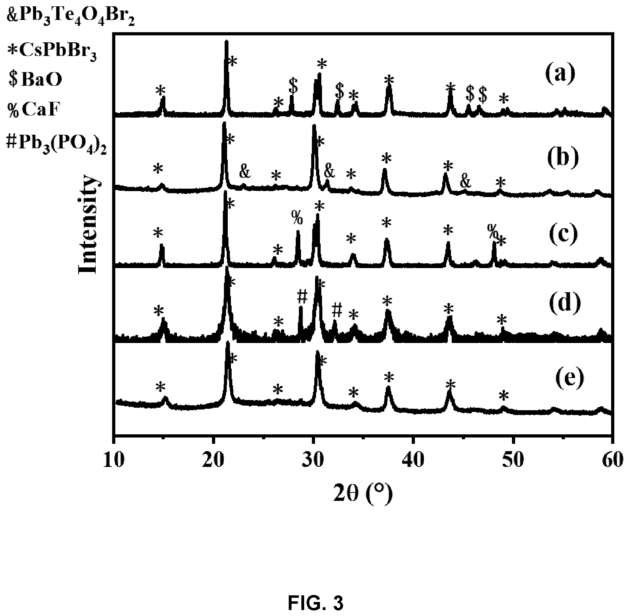

Experimental analysis: X-ray diffraction was carried out on the powder obtained above, and the specific results are shown in (a) of FIG. 3, where not only the $CsPbBr_3$ phase but also the BaO phase was presented in the sample. As a comparison, the X-ray diffraction spectrum of the sample powder calcined without $Ba(NO_2)_2$ showed the presence of only $CsPbBr_3$ phase and the absence of the BaO phase, as shown in (e) of FIG. 3. The X-ray diffraction proved that substrates of BaO and $CsPbBr_3$ nanocrystals coexisted in the present embodiment.

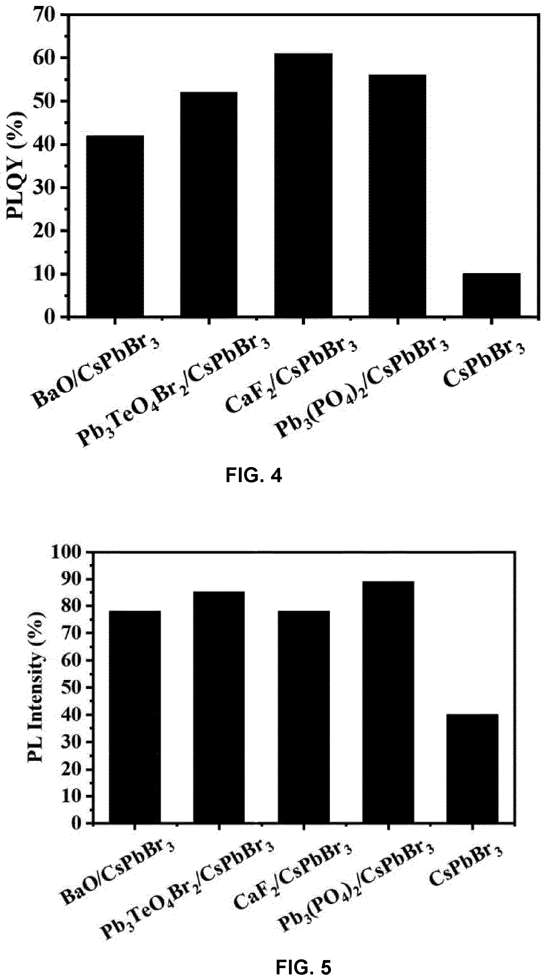

The powder obtained as described above was taken to test the fluorescence quantum yield (PLQY), and the results are shown in FIG. 4. The PLQY of this sample was 42%. As a comparison, the PLQY of the powder sample calcined without the addition of $Ba(NO_2)_2$ was 10%. The PLQY test results indicate that the presence of substrate BaO could enhance the luminous efficiency of the $CsPbBr_3$ nanocrystal, which verifies that the substrate BaO could passivate the surface of the $CsPbBr_3$ nanocrystals.

The powder obtained as described above was taken and tested for the stability of the powder in an environment of strong blue light irradiation, and the specific results are shown in FIG. 5. The luminous intensity of the powder was able to maintain 78% of the original intensity after continuous irradiation with 350 mW/cm$^2$ of blue light (wavelength 450 nm) for 100 h. The PL Intensity (%) in FIG. 5 represents the relative photoluminescence intensity. The relative photoluminescence intensity refers to an actual measured photoluminescence intensity relative to a photoluminescence intensity of a reference value or a reference point. The PL Intensity (%) can be expressed as:

PL Intensity (%) = photoluminescence intensity of the material after 100 hours under blue light test conditions/initial photoluminescence intensity of the material prior to testing x 100%.

As a comparison, after 100 hours under the same blue light test condition, the luminous intensity of the powder sample calcined without Ba(NO$_2$)$_2$ was decreased to 40% of the initial intensity. The blue-light stability proves that the substrate BaO is favorable to improving the photostability of CsPbBr$_3$.

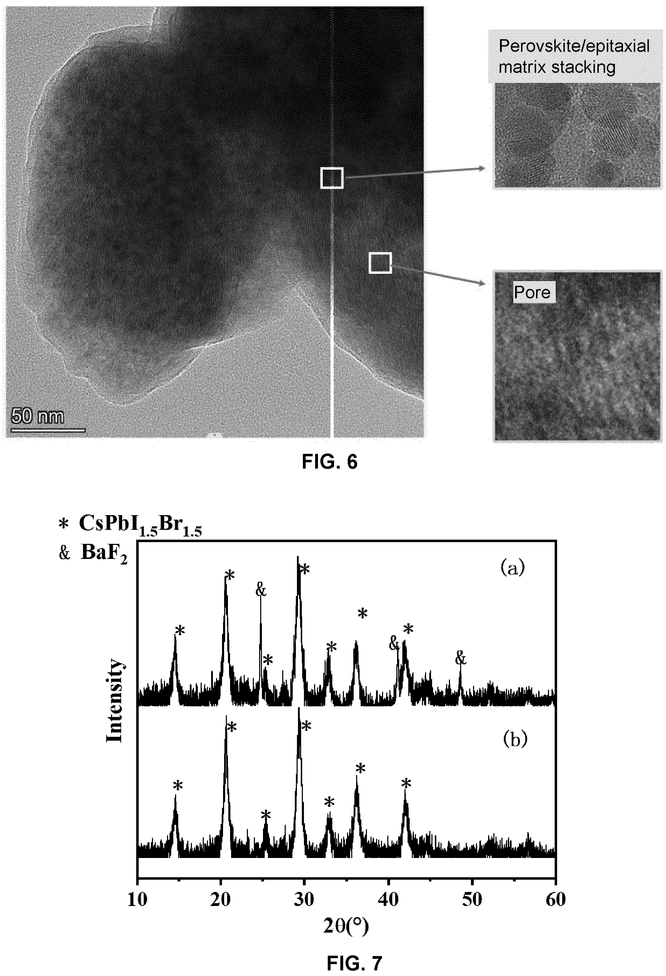

The microstructure of the powder obtained as described above was observed under a transmission electron microscope, the test results of the transmission electron microscope are shown in FIG. 6, the mesoporous silica pore structure is well maintained, and the perovskite nanocrystal and the substrate are stacked with each other.

## Embodiment 2

The substrate in the perovskite nanocrystal fluorescent material prepared in this embodiment was Pb$_3$TeO$_4$X$_2$, and the perovskite nanocrystal was CsPbBr3 perovskite nanocrystal.

5 mmol of CsBr, 7 mmol of PbBr$_2$, 2 mmol of TeBr$_4$, and 2 g of mesoporous silica were ground and mixed to obtain a solid mixed powder.

The above mixed powder was placed in a muffle furnace and heated from the room temperature to 585 °C. After heated continuously at 585 °C for 40 minutes, the sample powder was naturally cooled down to the room temperature and then removed.

During the calcination process, oxygen adsorbed by the mesoporous silica and TeBr$_4$ coreacted with PbBr$_2$ to form Pb$_3$TeO$_4$Br$_2$ as the substrate for the perovskite nanocrystal. The melting point of TeBr$_4$ is 380 °C, the melting point of PbBr$_2$ is 373 °C, and the melting point of Pb$_3$TeO$_4$Br$_2$ is higher than 700 °C.

Experimental analysis: X-ray diffraction was carried out on the powder obtained above, and the specific results are shown in (b) of FIG. 3, where not only the CsPbBr$_3$ phase but also the Pb$_3$TeO$_4$Br$_2$ phase was presented in the sample. As a comparison, only the CsPbBr$_3$ phase was presented in the X-ray diffraction spectrum of the powder sample calcined without the addition of TeBr$_4$, and the Pb$_3$TeO$_4$Br$_2$ phase was not presented (the specific results are shown in (e) of FIG. 3). The X-ray diffraction proved that the substrates of Pb$_3$TeO$_4$Br$_2$ and the CsPbBr$_3$ nanocrystals coexisted in the present embodiment.

The powder obtained as described above was taken to test the fluorescence quantum yield (PLQY), and the results are shown in FIG. 4. The PLQY of this sample was 52%. As a comparison, the PLQY of the powder sample calcined without the addition of TeBr$_4$ was 10%. The results of the PLQY test indicate that the presence of substrate Pb$_3$TeO$_4$Br$_2$ could enhance the luminous efficiency of the CsPbBr$_3$ nanocrystal, which verifies that the substrate Pb$_3$TeO$_4$Br$_2$ could passivate the surface of the CsPbBr$_3$ nanocrystal.

The powder obtained in this embodiment was taken to test the stability in an environment of strong blue light irradiation, and the specific results are shown in FIG. 5. The luminous intensity of the powder was able to maintain 85% of the original intensity after continuous irradiation with a blue light (wavelength 450 nm) of 350 mW/cm$^2$ for 100 hours. As a comparison, after 100 hours under the same blue light test condition, the luminous intensity of the powder sample calcined without adding TeBr$_4$ decreased to 40% of the initial intensity. The blue-light stability proves that the substrate Pb$_3$TeO$_4$Br$_2$ is favorable for improving the photostability of CsPbBr$_3$.

## Embodiment 3

The substrate in the perovskite nanocrystal fluorescent material prepared in this embodiment was CaF2, and the perovskite nanocrystal was CsPbBr$_3$ perovskite nanocrystal.

5 mmol of CsBr, 5 mmol of PbBr$_2$, 2 mmol of KF, 1 mmol of CaBr$_2$, and 2 g of mesoporous silica were ground and mixed to obtain a solid mixed powder.

The above mixed powder was placed in a muffle furnace and heated from the room temperature to 590 °C. After heated continuously at 590 °C for 40 minutes, the sample powder was naturally cooled down to the room temperature and then removed.

During the calcination process, KF reacted with CaBr$_2$ to form CaF$_2$ as the substrate for the perovskite nanocrystal. The melting point of KF is 858 °C and the melting point of $CaBr_2$ is 730°C. In the system, $PbBr_2$ acted as the precursor for the perovskite nanocrystal while also acting as a flux, and thus KF and $CaBr_2$ were able to co-melt below 590 °C. The melting point of $CaF_2$ produced by the reaction is 1402 °C.

Experimental analysis: X-ray diffraction was carried out on the powder obtained in the embodiment, and the specific results are shown in (c) of FIG. 3, where not only the $CsPbBr_3$ phase, but also the $CaF_2$ phase was presented in the sample. As a comparison, without the addition of KF and $CaBr_2$, only the $CsPbBr_3$ phase was presented in the X-ray diffraction spectrum of the calcined powder sample, and no $CaF_2$ phase was presented, and the specific results are shown in (e) of FIG. 3. The X-ray diffraction proved that the substrates of $CaF_2$ and $CsPbBr_3$ nanocrystals coexisted in the present embodiment.

The powder obtained as described above was taken to test the fluorescence quantum yield (PLQY), and the results are shown in FIG. 4. The PLQY of this sample was 61%. As a comparison, the PLQY of the powder sample calcined without the addition of KF and $CaBr_2$ was 10%. The results of the PLQY test indicate that the presence of substrate $CaF_2$ could enhance the luminous efficiency of the $CsPbBr_3$ nanocrystal, which verifies that the substrate $CaF_2$ could passivate the surface of the $CsPbBr_3$ nanocrystal.

The powder obtained above was taken to test the stability in an environment of strong blue light irradiation, and the specific results are shown in FIG. 5. The luminous intensity of the powder was able to maintain 78% of the original intensity after continuous irradiation with a blue light (wavelength 450 nm) of 350 mW/cm$^2$ for 100 hours. As a comparison, after 100 hours under the same blue light test condition, the luminous intensity of the powder sample calcined without adding KF and $CaBr_2$ decreased to 40% of the initial intensity. The blue-light stability proves that the substrate $CaF_2$ is favorable to improving the photostability of $CsPbBr_3$.

**Embodiment 4**

The substrate in the perovskite nanocrystal fluorescent material prepared in this embodiment was $Pb_3(PO_4)_2$, and the perovskite nanocrystal was $CsPbBr_3$ perovskite nanocrystal.

5 mmol of CsBr, 8 mmol of $PbBr_2$, 2 mmol of $H_4P_2O_7$, and 2 g of mesoporous silica were ground and mixed to obtain a solid mixed powder.

The above mixed powder was placed in a muffle furnace and heated from the room temperature to 580 °C. After heated continuously at 580 °C for 40 minutes, the sample powder was naturally cooled down to the room temperature and then removed.

During the calcination process, $H_4P_2O_7$ reacted with $PbBr_2$ to form $Pb_3(PO_4)_2$ as the substrate for the perovskite nanocrystal. The melting points of $H_4P_2O_7$, $PbBr_2$, and $Pb_3(PO_4)_2$ are 61 °C, 373 °C, and 1014 °C, respectively.

Experimental analysis: X-ray diffraction was carried out on the powder obtained as described above, and the specific results are shown in (d) of FIG. 3, where not only the $CsPbBr_3$ phase but also the $Pb_3(PO_4)_2$ phase was presented in the sample. As a comparison, the X-ray diffraction spectrum of the sample powder calcined without $H_4P_2O_7$ showed the presence of only $CsPbBr_3$ phase and the absence of the $Pb_3(PO_4)_2$ phase, as shown in (e) of FIG. 3. The X-ray diffraction proved that the substrates of $Pb_3(PO_4)_2$ and $CsPbBr_3$ nanocrystals coexisted in the present embodiment.

The powder obtained as described above was taken to test the fluorescence quantum yield (PLQY), and the results are shown in FIG. 4. The PLQY of this sample was 56%. As a comparison, the PLQY of the powder sample calcined without the addition of $H_4P_2O_7$ was 10%. The results of the PLQY test indicate that the presence of substrate $Pb_3(PO_4)_2$ could enhance the luminous efficiency of the $CsPbBr_3$ nanocrystal, which verifies that the substrate $Pb_3(PO_4)_2$ could passivate the surface of the $CsPbBr_3$ nanocrystal.

The powder obtained above was taken to test the stability in an environment of strong blue light irradiation, and the specific results are shown in FIG. 5. The luminous intensity of the powder was able to maintain 89% of the original intensity after continuous irradiation with a blue light (wavelength 450 nm) of 350 mW/cm$^2$ for 100 hours. As a comparison, after 100 hours under the same blue light test condition, the luminous intensity of the powder sample calcined without $H_4P_2O_7$ decreased to 40% of the initial intensity. The blue-light stability proves that the substrate $Pb_3(PO_4)_2$ is favorable to improving the photostability of $CsPbBr_3$.

**Embodiment 5**

The substrate in the perovskite nanocrystal fluorescent material prepared in this embodiment was $BaF_2$, and the perovskite nanocrystal was $CsPbI_{1.5}Br_{1.5}$ perovskite nanocrystal.

5 mmol $Cs_2CO_3$, 5 mmol $PbBr_2$, 5 mmol $PbI_2$, 2 mmol KF, 1 mmol $Ba(OH)_2$, and 2 g of mesoporous silica were ground and mixed to obtain a solid mixed powder.

The above mixed powder was placed in a muffle furnace and heated from the room temperature to 590 °C. After heated continuously at 590 °C for 40 minutes, the sample powder was naturally cooled down to the room temperature and then removed.

During the calcination process, KF reacted with $Ba(OH)_2$ to form $BaF_2$ as the substrate for the perovskite nanocrystal. The melting point of KF is 858 °C, the melting point of $Ba(OH)_2$ is 350 °C, and the melting point of $BaF_2$ is 1,354 °C. In the above description, $PbBr_2$ was used as a flux and a lead source precursor. The melting point of $CsPbI_{1.5}Br_{1.5}$ perovskite nanocrystal is lower than 550 °C.

Experimental analysis: X-ray diffraction was carried out on the powder obtained in the embodiment, and the specific results are shown in FIG. 7. As shown in (a) in FIG. 7, not only the $CsPbI_{1.5}Br_{1.5}$ phase, but also the $BaF_2$ phase was presented in the sample. As a comparison, as shown in (b) of FIG. 7, without the addition of KF and $Ba(OH)_2$, only the $CsPbI_{1.5}Br_{1.5}$ phase was presented in the X-ray diffraction spectrum of the calcined powder sample, and no $BaF_2$ phase was presented. The X-ray diffraction proved that the substrates of $BaF_2$ and $CsPbI_{1.5}Br_{1.5}$ nanocrystals coexisted in the present embodiment.

The powder obtained by calcination in the present embodiment was taken to test the fluorescence quantum yield (PLQY), and the specific results are shown in FIG. 4. The PLQY of this sample was 77%. As a comparison, the PLQY of the sample without the addition of $BaF_2$ was 18%. The PLQY test results illustrate that the presence of substrate $BaF_2$ could enhance the luminous efficiency of the $CsPbI_{1.5}Br_{1.5}$ nanocrystal, which verifies that the substrate $BaF_2$ could passivate the surface of the $CsPbI_{1.5}Br_{1.5}$ nanocrystal. It demonstrates that the method proposed in the embodiments of the present disclosure is equally applicable to the mixed halide perovskite nanocrystal.

**Embodiment 6**

The substrate in the perovskite nanocrystal fluorescent material prepared in this embodiment was $BaF_2$, and the perovskite nanocrystal was $CsSnBr_3$ perovskite nanocrystal.

5 mmol of CsBr, 5 mmol of $SnBr_2$, 2 mmol of KF, 1 mmol of $BaBr_2$, and 2 g of mesoporous silica were ground and mixed to obtain a solid mixed powder.

The above mixed powder was placed in a muffle furnace with nitrogen atmosphere and heated from the room temperature to 580 °C. After heated continuously at 580 °C for 30 minutes, the sample powder was naturally cooled down to the room temperature and then removed.

During the calcination process, CsBr and $SnBr_2$ reacted to form cesium-lead-tin perovskite, and KF reacted with $BaBr_2$ to form $BaF_2$ as the substrate for the perovskite nanocrystal. The melting point of the $CsSnBr_3$ perovskite nanocrystal is lower than 550 °C. In the above description, $SnBr_2$ was used as a flux and a Sn source precursor. It demonstrates that the method presented in the embodiments of the present disclosure is equally applicable to cesiumtin perovskite nanocrystal.

**Embodiment 7**

The substrate in the perovskite nanocrystal fluorescent material prepared in this embodiment was $BaF_2$, and the prepared perovskite nanocrystal was $CsCuI_3$ perovskite nanocrystal.

5 mmol of CsI, 10 mmol of CuI, 2 mmol of KF, 1 mmol of $BaI_2$, and 2 g of mesoporous titanium dioxide were ground and mixed to obtain a solid mixed powder.

The above mixed powder was placed in a muffle furnace with nitrogen atmosphere and heated from the room temperature to 750 °C. After heated continuously at 750 °C for 30 minutes, the sample powder was naturally cooled down to the room temperature and then removed.

During the calcination process, CsI and CuI reacted to form $CsCuI_3$ perovskite nanocrystal, and KF reacted with $BaI_2$ to form $BaF_2$ as the substrate. In the above description, CuI was used as a flux and a Cu source precursor. It demonstrates that the method presented in the embodiments of the present disclosure is equally applicable to Cu-based perovskite nanocrystal.

The substrates in the perovskite nanocrystal fluorescent materials ultimately prepared in Embodiments 5-7 are all $BaF_2$, but the precursors of the substrates are all different. It can be seen that under the premise of conforming to the inventive conception of the present disclosure, the corresponding precursors of the substrates may be arbitrarily selected to react to form the same substrate. It should be noted that the simple substitution of the precursors of the substrate should be included in the scope of protection of the present disclosure.

**Embodiment 8**

The difference from Embodiment 1 is in the substrate, which in this embodiment is CaO.

The precursor of the substrate was $Ca(NO_2)_2$, and $Ca(NO_2)_2$ had a melting point of 390° C. $Ca(NO_2)_2$ was heated, melted, and adsorbed into mesoporous silica pores, and was further heated and decomposed into CaO to serve as the substrate for the perovskite nanocrystal. CaO has a melting point of 2572 °C.

The powder obtained in this embodiment was tested with a PLQY of 50%, and the test results illustrated that the presence of the substrate CaO could enhance the luminous efficiency of the CsPbBr$_3$ nanocrystal, verifying that the substrate CaO could passivate the surface of the CsPbBr$_3$ nanocrystal.

**Embodiment 9**

The difference from Embodiment 1 is in the substrate, which in this embodiment is Al$_2$O$_3$.

The precursor of the substrate was aluminum sec-butoxide, which had a melting point of 30 °C. During heating, aluminum sec-butoxide was adsorbed into the mesoporous silica pores, and was further heated and decomposed into Al$_2$O$_3$ to serve as the substrate for the perovskite nanocrystal. Al$_2$O$_3$ has a melting point of 2054 °C.

The powder obtained in this embodiment was tested with a PLQY of 49%, and the test results indicated that the presence of the substrate Al$_2$O$_3$ could enhance the luminous efficiency of the CsPbBr$_3$ nanocrystal, which verifies that the substrate Al$_2$O$_3$ could passivate the surface of the CsPbBr$_3$ nanocrystal.

**Comparative embodiment 1**

There is no substrate in this comparative embodiment, and the perovskite nanocrystal obtained in this comparative embodiment is CsPbBr$_3$ perovskite nanocrystal.

5 mmol of CsBr, 5 mmol of PbBr$_2$, and 2 g of mesoporous silica were ground and mixed to obtain a solid mixed powder.

The above mixed powder was placed in a muffle furnace and heated from the room temperature to 585 °C. After heated continuously at 585 °C for 40 minutes, the sample powder was naturally cooled down to the room temperature and then removed.

Experimental analysis: X-ray diffraction was carried out on the powder obtained by calcination as described above, and the specific results are shown in (e) of FIG. 3. Only the CsPbBr$_3$ phase was presented in the X-ray diffraction spectrum of the calcined powder sample, and no other phases were presented.

The powder obtained from the above calcination was taken to test the PLQY, and the specific results are shown in FIG. 4. The PLQY of this sample was 10%, indicating that the substrate-free CsPbBr$_3$ nanocrystal lacked a surface passivation substrate, and the surface defects caused a severe quenching of the fluorescence.

The powder obtained by calcination as described above was taken to test the stability in an environment of strong blue light irradiation, and the specific results are shown in FIG. 5. The luminous intensity of the powder was able to maintain 40% of the original intensity after continuous irradiation with a blue light (wavelength 450 nm) of 350 mW/cm$^2$ for 100 hours, which indicates that the substrate-free CsPbBr$_3$ nanocrystal is poorly stabilized.

**Comparative embodiment 2**

The calcination temperature provided in this comparative embodiment is higher than the failure temperature of the micro-porous template and/or the mesoporous template, and perovskite nanocrystal obtained in this comparative embodiment is CsPbBr$_3$ perovskite nanocrystal.

5 mmol of CsBr, 5 mmol of PbBr$_2$, and 2 g of mesoporous silica were ground and mixed to obtain a solid mixed powder.

The above mixed powder was placed in a muffle furnace and heated from the room temperature to 620 °C. After heated continuously at 620 °C for 40 minutes, the sample powder was naturally cooled down to the room temperature and then removed. When the temperature is higher than 600°C, the pores of the mesoporous silica collapsed and closed.

The PLQY of the powder obtained from the above calcination was only 2%, which was smaller than the PLQY of the calcined product of Comparative embodiment 1 (in Comparative embodiment 1, calcination was carried out at 585°C, which is lower than the failure temperature of the growth template, and the PLQY = 10%), suggesting that it is difficult to produce high-quality calixarene quantum dots after the failure of the mesoporous silica used as the growth template.

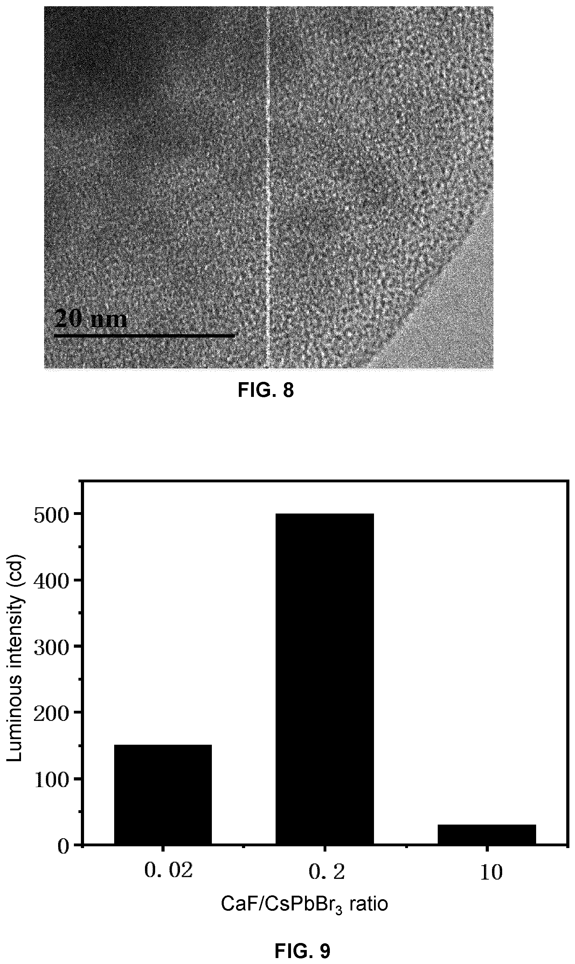

The microstructure of the powder obtained as described above was observed under a transmission electron microscope. As shown in FIG. 8, the mesoporous silica pores are completely collapsed, and almost no quantum dots existed therein, further indicating that it is difficult to adsorb the precursor and grow perovskite quantum dots after the failure of the mesoporous silica used as the growth template.

**Comparative embodiment 3**

The comparative embodiment provides a perovskite nanocrystal fluorescent material obtained when prepared in an excess or small amount of substrate.

5 mmol of CsBr, 5 mmol of PbBr$_2$, 2 mmol of KF, 1 mmol of CaBr$_2$, and 2 g of mesoporous silica were ground and mixed to obtain a solid mixed powder. The solid mixed powder was placed in a muffle furnace and heated from the room temperature to 590 °C. After heated continuously at 590 °C for 40 minutes, the sample powder was naturally cooled down to the room temperature and then removed. A CaF/CsPbBr$_3$ ratio of 1:5 in the sample was obtained based on the precursor feeding ratio.

5 mmol of CsBr, 5 mmol of PbBr$_2$, 100 mmol of KF, 50 mmol of CaBr$_2$, and 2 g of mesoporous silica were ground and mixed to obtain a solid mixed powder. The solid mixed powder was placed in a muffle furnace and heated from the room temperature to 590 °C. After heated continuously at 590 °C for 40 minutes, the sample powder was naturally cooled down to the room temperature and then removed. A CaF/CsPbBr$_3$ ratio of 10:1 in the sample was obtained based on the precursor feeding ratio.

5 mmol of CsBr, 5 mmol of PbBr$_2$, 0.2 mmol of KF, 0.1 mmol of CaBr$_2$, and 2 g of mesoporous silica were ground and mixed to obtain a solid mixed powder. The solid mixed powder was placed in a muffle furnace and heated from the room temperature to 590 °C. After heated continuously at 590 °C for 40 minutes, the sample powder was naturally cooled down to the room temperature and then removed. A CaF/CsPbBr$_3$ ratio of 1:50 in the sample was obtained based on the precursor feeding ratio.

As shown in FIG. 9, the result of the luminous intensity of the above three samples measured under the same excitation light is that the luminous intensity of the sample with a CaF/CsPbBr$_3$ ratio of 5:1 is stronger than the luminous intensity of the samples with ratios of 1:10 and 50:1, which indicates that the ratio of the substrate to the perovskite has an effect on the luminous intensity. Both too small and too large ratios will weaken the luminosity of the samples. Therefore, the ratio of substrate to perovskite should be appropriate.

The basic concepts have been described above, apparently, in detail, as will be described above, and do not constitute limitations of the disclosure. Although there is no clear explanation here, those skilled in the art may make various modifications, improvements, and modifications of the present disclosure.

At the same time, the present disclosure uses specific words to describe the embodiments of the present disclosure. As "one embodiment," "an embodiment," and/or "some embodiments" means a certain feature, structure, or characteristic of at least one embodiment of the present disclosure. Therefore, it is emphasized and should be appreciated that two or more references to "an embodiment" or "one embodiment" or "an alternative embodiment" in various parts of the present disclosure are not necessarily all referring to the same embodiment. Further, certain features, structures, or features of one or more embodiments of the present disclosure may be combined.

In addition, unless clearly stated in the claims, the order of processing elements and sequences, the use of numbers and letters, or the use of other names in the present disclosure are not used to limit the order of the procedures and methods of the present disclosure. Although the above disclosure discusses through various examples what is currently considered to be a variety of useful embodiments of the disclosure, it is to be understood that such detail is solely for that purpose, and that the appended claims are not limited to the disclosed embodiments, but, on the contrary, are intended to cover modifications of the disclosed embodiments. For example, although the implementation of various components described above may be embodied in a hardware device, it may also be implemented as a software only solution, e.g., an installation on an existing server or mobile device.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. However, this disclosure does not mean that the present disclosure object requires more features than the features mentioned in the claims. Rather, claimed subject matter may lie in less than all features of a single foregoing disclosed embodiment.

In some embodiments, the numbers expressing quantities of ingredients, properties, and so forth, used to describe and claim certain embodiments of the application are to be understood as being modified in some instances by the term "about," "approximate," or "substantially." Unless otherwise stated, "about," "approximate," or "substantially" may indicate $\pm 20\%$ variation of the value it describes. Accordingly, in some embodiments, the numerical parameters used in the specification and claims are approximate values, and the approximation may change according to the characteristics required by the individual embodiments. In some embodiments, the numerical parameter should consider the prescribed effective digits and adopt a general digit retention method. Although in some embodiments, the numerical fields and parameters used to confirm the breadth of its range are approximate values, in specific embodiments, such numerical values are set as accurately as possible within the feasible range.

Application history documents that are inconsistent with the contents of the present disclosure or that create conflicts are excluded, as are documents (currently or hereafter appended to the present disclosure) that limit the broadest scope of the claims of the present disclosure. It should be noted that in the event of any inconsistency or conflict between the descriptions, definitions, and/or use of terms in the materials appended to the present disclosure and those described in the present disclosure, the descriptions, definitions, and/or use of terms in the present disclosure shall prevail.

At last, it should be understood that the embodiments described in the present disclosure are merely illustrative of the principles of the embodiments of the present disclosure. Other modifications that may be employed may be within the scope of the present disclosure. Thus, by way of example, but not of limitation, alternative configurations of the embodiments of the present disclosure may be utilized in accordance with the teachings herein. Accordingly, embodiments of the present disclosure are not limited to that precisely as shown and described.

**Claims**

1. A method for preparing a perovskite nanocrystal fluorescent material, comprising the following steps:

(1) mixing a precursor of a perovskite nanocrystal, a precursor of a substrate, and at least one of a micro-porous template or a mesoporous template to obtain a mixture; and
(2) under a temperature higher than a melting point of the perovskite nanocrystal and lower than a failure temperature of the at least one of the micro-porous template or the mesoporous template, performing calcination on the mixture obtained in step (1), and after cooling the mixture to a room temperature, obtaining the perovskite nanocrystal fluorescent material;
wherein the calcination in step (2) is composed of a heating-melting stage, an insulation-filling stage, and a cooling-growth stage in sequence;
during the heating-melting stage, when a calcination temperature is higher than the melting point of the perovskite nanocrystal, the precursor of the perovskite nanocrystal and the precursor of the substrate form a molten liquid;
during the insulation-filling stage, when the calcination temperature is lower than the failure temperature of the at least one of the micro-porous template or the mesoporous template, the molten liquid fills a pore structure of the at least one of the micro-porous template or the mesoporous template; and
during the cooling-growth stage, the substrate is formed inside the micro-porous template or the mesoporous template, and after the substrate is formed, the perovskite nanocrystal heterogeneously grows on a surface of the substrate, thus obtaining the perovskite nanocrystal fluorescent material; wherein a melting point of the precursor of the substrate is lower than a melting point of the substrate;
wherein the substrate is arranged on an inner surface of the at least one of the micro-porous template or the mesoporous template;
a lattice of the perovskite nanocrystal stacks with a lattice of the substrate to form a passivation interface; and
the melting point of the substrate is higher than the melting point of the perovskite nanocrystal.

2. The method according to claim 1, wherein the step (1) further includes:
using a low melting point salt corresponding to any precursor of the precursor of the perovskite nanocrystal or the precursor of the substrate as a flux.

**Patentansprüche**

1. Ein Verfahren zur Herstellung eines Perowskit-Nanokristall-Fluoreszenzmaterials, umfassend die folgenden Schritte:

(1) Mischen eines Vorläufers eines Perowskit-Nanokristalls, eines Vorläufers eines Substrats sowie mindestens eines von einer mikroporösen Schablone oder einer mesoporösen Schablone, um ein Gemisch zu erhalten; und
(2) bei einer Temperatur, die höher ist als ein Schmelzpunkt des Perowskit-Nanokristalls und niedriger ist als eine Versagenstemperatur des mindestens einen von der mikroporösen Schablone oder der mesoporösen Schablone, Durchführen einer Kalzinierung des in Schritt (1) erhaltenen Gemisches, und nach dem Abkühlen des Gemisches auf Raumtemperatur Erhalten des Perowskit-Nanokristall-Fluoreszenzmaterials;
wobei die Kalzinierung in Schritt (2) der Reihe nach aus einer Heiz-Schmelz-Phase, einer Isolations-Füll-Phase und einer Abkühl-Wachstums-Phase zusammengesetzt ist;
während der Heiz-Schmelz-Phase, wenn eine Kalzinierungstemperatur höher ist als der Schmelzpunkt des Perowskit-Nanokristalls, bilden der Vorläufer des Perowskit-Nanokristalls und der Vorläufer des Substrats eine geschmolzene Flüssigkeit;
während der Isolations-Füll-Phase, wenn die Kalzinierungstemperatur niedriger ist als die Versagenstemperatur des mindestens einen von der mikroporösen Schablone oder der mesoporösen Schablone, füllt die geschmolzene Flüssigkeit eine Porenstruktur des mindestens einen von der mikroporösen Schablone oder der mesoporösen Schablone; und
während der Abkühl-Wachstums-Phase wird das Substrat innerhalb der mikroporösen Schablone oder der mesoporösen Schablone gebildet, und nachdem das Substrat gebildet ist, wächst der Perowskit-Nanokristall heterogen auf einer Oberfläche des Substrats, wodurch das Perowskit-Nanokristall-Fluoreszenzmaterial erhalten wird; wobei ein Schmelzpunkt des Vorläufers des Substrats niedriger ist als ein Schmelzpunkt des Substrats;

wobei das Substrat auf einer inneren Oberfläche des mindestens einen von der mikroporösen Schablone oder der mesoporösen Schablone angeordnet ist;

ein Gitter des Perowskit-Nanokristalls mit einem Gitter des Substrats gestapelt ist, um eine Passivierungsschnittstelle zu bilden; und

der Schmelzpunkt des Substrats höher ist als der Schmelzpunkt des Perowskit-Nanokristalls.

2. Das Verfahren nach Anspruch 1, wobei der Schritt (1) ferner umfasst:

Verwenden eines Niedrigschmelzpunktsalzes, das einem beliebigen Vorläufer unter dem Vorläufer des Perowskit-Nanokristalls oder dem Vorläufer des Substrats entspricht, als Flussmittel.

## Revendications

1. Un procédé de préparation d'un matériau fluorescent à nanocristaux de pérovskite, comprenant les étapes suivantes :

(1) mélanger un précurseur de nanocristal de pérovskite, un précurseur de substrat, et au moins l'un d'un gabarit micro-poreux ou d'un gabarit mésoporeux afin d'obtenir un mélange ; et

(2) à une température supérieure à un point de fusion du nanocristal de pérovskite et inférieure à une température de défaillance de l'au moins l'un du gabarit micro-poreux ou du gabarit mésoporeux, effectuer une calcination du mélange obtenu à l'étape (1), et après avoir refroidi le mélange à une température ambiante, obtenir le matériau fluorescent à nanocristaux de pérovskite ;

dans lequel la calcination de l'étape (2) est composée successivement d'une étape de chauffage-fusion, d'une étape d'isolation-remplissage, et d'une étape de refroidissement-croissance ;

pendant l'étape de chauffage-fusion, lorsque une température de calcination est supérieure au point de fusion du nanocristal de pérovskite, le précurseur du nanocristal de pérovskite et le précurseur du substrat forment un liquide fondu ;

pendant l'étape d'isolation-remplissage, lorsque la température de calcination est inférieure à la température de défaillance de l'au moins l'un du gabarit micro-poreux ou du gabarit mésoporeux, le liquide fondu remplit une structure poreuse de l'au moins l'un du gabarit micro-poreux ou du gabarit mésoporeux ; et

pendant l'étape de refroidissement-croissance, le substrat est formé à l'intérieur du gabarit micro-poreux ou du gabarit mésoporeux, et après que le substrat est formé, le nanocristal de pérovskite croît de manière hétérogène sur une surface du substrat, permettant ainsi d'obtenir le matériau fluorescent à nanocristaux de pérovskite ; dans lequel un point de fusion du précurseur du substrat est inférieur à un point de fusion du substrat ;

dans lequel le substrat est disposé sur une surface interne de l'au moins l'un du gabarit micro-poreux ou du gabarit mésoporeux ;

un réseau cristallin du nanocristal de pérovskite s'empile avec un réseau cristallin du substrat afin de former une interface de passivation ; et

le point de fusion du substrat est supérieur au point de fusion du nanocristal de pérovskite.

2. Le procédé selon la revendication 1, dans lequel l'étape (1) comprend en outre :

utiliser un sel à bas point de fusion correspondant à tout précurseur parmi le précurseur du nanocristal de pérovskite ou le précurseur du substrat en tant que flux.

Passivation interface
formed by a lattice
of perovskite
nanocrystal stacked
with a lattice of a
substrate

Substrate

Perovskite
nanocrystal

Passivation interface
formed by a lattice of
perovskite nanocrystal
stacked with a lattice
of a substrate

**FIG. 1**

Precursor mixture + Micro-porous template and/or mesoporous template → Heating → Molten liquid enters the growth template

Cooling down

Growth of the perovskite nanocrystal and the substrate within the template

FIG. 2

**FIG. 3**

17

FIG. 4

FIG. 5

FIG. 6

FIG. 7

FIG. 8

FIG. 9

**EP 4 379 019 B1**

**REFERENCES CITED IN THE DESCRIPTION**

**Patent documents cited in the description**

- WO 2022024037 A1

- CN 114316969 A